# EUROPEAN PATENT APPLICATION

(11) **EP 4 531 100 A1**
(43) Date of publication of application: **02.04.2025**
(21) Application number: 24196197.8
(22) Date of filing: 23.08.2024
(51) Int. Cl.: H01L 23/48, H01L 23/528

(54) **SYSTEMS AND METHODS FOR POWER DELIVERY FOR SEMICONDUCTOR DEVICES**

(30) Priority: 27.09.2023 US 202318475566
(71) Applicant: Avago Technologies International Sales Pte. Limited, Singapore 768923 (SG)
(72) Inventor: Tufano, AJ, Fort Collins, 80528 (US); Gentry, Jason T., Windsor, 80550 (US)
(74) Representative: Dilg, Haeusler, Schindelmann Patentanwaltsgesellschaft mbH

(57) **Abstract**

The subject technology is directed to systems and methods for power delivery in semiconductor devices. According to an embodiment, the subject technology provides a semiconductor device including a substrate comprising a first side and a second side. A first connection is coupled to the first side and a grid is coupled to the second side. The semiconductor device further comprises a first via coupled to the first connection and the grid, the first via is configured to transmit electrical power between the first side and the second side. In some implementations, the first via may be configured to improve the uniformity of power delivery and distribution, allowing for optimal circuit design and thermal effects. There are other embodiments as well.

## Description

### FIELD OF INVENTION

The subject technology is directed to systems and methods for power delivery for semiconductor devices.

### BACKGROUND OF THE INVENTION

Over the past decade, advancements in the design of three-dimensional (3D) semiconductor packaging have been of significant interest to the semiconductor industry. Various designs involve using through-silicon vias (TSVs) for power delivery and distribution. For example, a semiconductor device may include two or more circuit elements stacked vertically, interconnected by vias that pass through the silicon substrate to establish electrical connections and provide power distribution across the semiconductor package. However, the inclusion of TSVs introduces significant resistance to the power delivery path, presenting a substantial burden on the power grid to distribute current uniformly among the circuit elements. Additionally, the placement of TSVs often necessitates a sizable keep-out zone right below the circuit elements, which may disrupt the circuitry layout, potentially hampering routing efficiency and compromising the integrity of the circuit design.

Various approaches for enhancing power delivery for semiconductor devices have been explored, but they have proven to be insufficient. It is important to recognize the need for new and improved systems and methods for power delivery in semiconductor devices.

### BRIEF DESCRIPTION OF THE DRAWINGS

Figure 1 is a simplified diagram illustrating a semiconductor device with a 3D interconnect structure according to the embodiments of the subject technology.
Figure 2 is a simplified diagram illustrating a semiconductor device with a 3D interconnect structure according to the embodiments of the subject technology.
Figure 3 is a simplified diagram illustrating a semiconductor device with a 3D interconnect structure according to the embodiments of the subject technology.
Figure 4 is a simplified diagram illustrating a top view of a semiconductor device having one or more vias according to the embodiments of the subject technology.
Figure 5 is a simplified diagram illustrating configurations of one or more vias in semiconductor devices according to the embodiments of the subject technology.
Figure 6 is a simplified diagram illustrating configurations of one or more vias in semiconductor devices according to the embodiments of the subject technology.
Figure 7 is a simplified diagram illustrating configurations of one or more vias in semiconductor devices according to the embodiments of the subject technology.

### DETAILED DESCRIPTION OF THE INVENTION

The subject technology is directed to systems and methods for power delivery in semiconductor devices. According to an embodiment, the subject technology provides a semiconductor device including a substrate comprising a first side and a second side. A first connection is coupled to the first side and a grid is coupled to the second side. The semiconductor device further comprises a first via coupled to the first connection and the grid, the first via is configured to transmit electrical power between the first side and the second side. In some implementations, the first via may be configured to improve the uniformity of power delivery and distribution, allowing for optimal circuit design and thermal dissipation. There are other embodiments as well.

3D integrated circuits (IC) may refer to semiconductor circuits manufactured by vertically stacking two or more semiconductor or chip modules (e.g., integrated circuits, chip, or other circuit elements). Interconnections between these semiconductor modules can be realized using TSVs and/or metal connections (e.g., Cu-Cu connections). Some approaches establish power delivery paths by positioning TSVs in alignment with the backside bump to power the semiconductor modules with current coming from a substrate. Given the substantial power delivery demands of the backside bump (e.g., 300-400mA per bump)-which cannot be done through a single TSV-there is often a need to cluster a group of TSVs to directly attach to a single bump. Such a configuration introduces significant resistance to the power delivery path, posing challenges for the power grid in achieving a uniform current distribution across the circuits. Moreover, aligning the TSVs with the regular grid pattern of the backside bumps leads to sizeable "keep-out" zones that disrupt the layout of underlying circuits.

In various embodiments, the subject technology provides methods and systems for improving power delivery using finely distributed TSVs to enhance the uniformity of power distribution. For instance, the subject technology decouples the TSVs from the backside bump by introducing a grid coupled therebetween to facilitate the connection. This arrangement enables strategic and flexible placement of TSVs, tailored to match specific power delivery and circuit design requirements. It should be noted that this approach provides dynamic TSV allocation based on granular circuit-level power delivery requirements, leading to enhanced flexibility for routing and optimal thermal management. For instance, TSV placements can be placed around dense circuit structures such as static random-access memory (SRAM) arrays while mitigating disruptions in circuit layout and overall performance.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification, and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes a semiconductor device, which comprises a first connection. The semiconductor device also comprises a substrate with a first side and a second side. The first connection is coupled to the first side of the substrate. The substrate comprises a grid coupled to the second side and a second connection coupled to the grid. The semiconductor device comprises a first via coupled to the first connection and the grid, and a second via coupled to the first connection and the second connection. A first distance between the first via and the second via is less than 20um.

Implementations may include one or more of the following features. The first via is characterized by a maximum current of less than 40mA. The first connection comprises a power grid strap. The second connection comprises a solder bump. The first via comprises a through silicon via. The semiconductor device may further comprise a third connection coupled to the grid, and a distance between the second connection and the third connection is between 100um to 200um. The first via is configured to transmit electrical power between the first side and the second side.

Another aspect includes a semiconductor device, which comprises a first connection and a substrate. The substrate comprises a first opening and a second opening. The substrate may further comprise a first side and a second side. The first connection is coupled to the first side. The substrate comprises a grid coupled to the second side and a second connection coupled to the grid. The semiconductor device comprises a first via coupled to the first connection and the grid, and the first via comprises a first portion positioned in the first opening. The semiconductor device may comprise a second via coupled to the first connection and the grid, and the second via comprises a second portion positioned in the second opening. A first distance between the first via and the second via is less than 20um.

Implementations may include one or more of the following features. The semiconductor device may further comprise a third via and a plurality of vias. The plurality of vias is positioned between the third via and the second via. A second distance between the third via and the second via is less than 20um. The first via is characterized by a maximum current of less than 40mA. The first via comprises a through silicon via.

Yet another aspect includes a semiconductor device, which comprises a substrate. The substrate comprises a first side and a second side. The semiconductor device comprises a first connection coupled to the first side of the substrate. The semiconductor device comprises a grid coupled to the second side of the substrate, and the grid comprises a first region. The semiconductor device comprises a first via coupled between the first connection and the first region of the grid. The first via comprises a first portion positioned in a first opening of the substrate.

Implementations may include one or more of the following features. The semiconductor device may further comprise a second connection coupled to the first region of the grid. The second connection comprises a solder bump. The grid further comprises a second region, the second region is not coupled to the second connection. The semiconductor device further comprises a second via coupled between the first connection and the second region of the grid. The second via comprises a second portion positioned in a second opening of the substrate. A first distance between the first via and the second via is less than 20um. The first connection comprises a power grid strap. The first via is configured to transmit electrical power between the first side and the second side. The first via is characterized by a maximum current of less than 40mA.

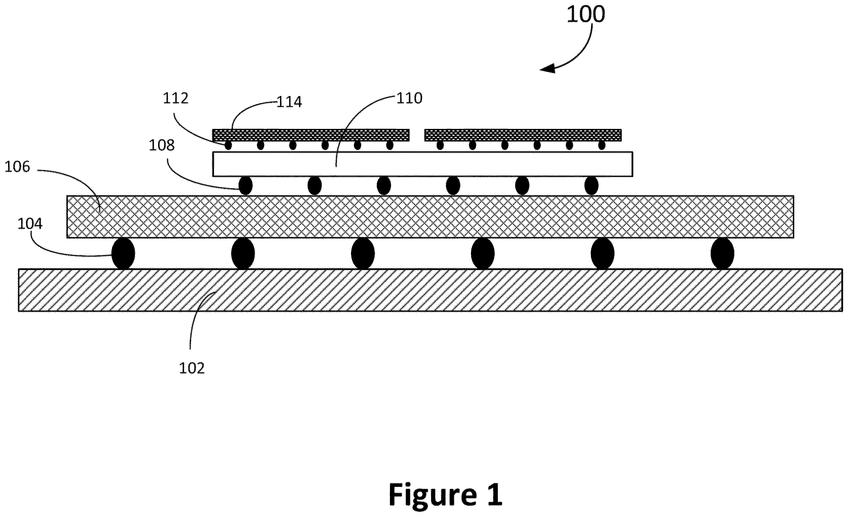

Figure 1 is a simplified diagram illustrating a semiconductor device 100 with a 3D interconnect structure according to the embodiments of the subject technology. This diagram is merely an example, which should not unduly limit the scope of the claims. One of ordinary skill in the art would recognize many variations, alternatives, and modifications. As shown, semiconductor device 100 includes a substrate 102. The term "substrate" can refer to a circuit board, on which integrated circuits and other electrical connections are mounted. The substrate can provide a stable platform for the components, along with the necessary electrical connections for them to interact and function as a complete system. For instance, substrate 102 provides a connection for semiconductor device 100 to a printed circuit board (PCB) (not shown) to facilitate electrical communication and power transfer.

Semiconductor device 100 may further include an interposer 106 coupled to substrate 102 via a ball connection 104. The term "interposer" may refer to an intermediate substrate or layer utilized in 2.5D or 3D IC circuits to facilitate electrical connections between stacked dies or between a die and a substrate (e.g., substrate 102). The interposer may comprise both silicon and organic materials. As an example, multiple circuits can be placed side-by-side on interposer 106 to achieve better interconnect density and performance. The individual circuit can be bonded to interposer 106 through ball connection 104. The term "ball connection" may refer to solder ball connections that are small, rounded points of solder that electrically and mechanically connect components or substrates. For instance, ball connection 104 could be utilized in ball grid array (BGA) configurations to attach interposer 106 to substrate 102.

In certain embodiments, semiconductor device 100 may be configured in a 3D stacking configuration and includes a first die 114 and a second die 110 coupled via an interconnect 112. For instance, the terms "die" or "semiconductor die" may refer to a piece or segment of semiconductor material (e.g., silicon), which contains integrated circuitry. This integrated circuitry can encompass various electronic components such as transistors, capacitors, resistors, and other microelectronic structures, which together perform specific electronic functions. As an example, first die 114 may be coupled to second die 110. Accordingly, the first die 114 may also be referred to as a "top die" and the second die 110 may be referred to as a "bottom die." It is to be appreciated that the terms "top" and "bottom" denote relative positional relationships and are not intended to imply strict vertical orientations. Interconnect 112 may include a hybrid copper bond, which can include a fusion of copper-based materials that facilitate electrical connection and thermal performance between semiconductor modules (e.g., first die 114 and second die 110). The hybrid copper bond could provide robust electrical paths while also offering superior heat dissipation characteristics in high-performance applications.

In a 3D stacking configuration, second die 110 may be coupled to interposer 106 via a backside bump 108. The term "backside bump" may refer to a protrusion on the back of a semiconductor module (e.g., a circuit, a die, a chip module, etc.). The backside bump can be used for connecting stacked dies or chips and facilitate dense and reliable interconnections. Backside bump 108 may include but is not limited to, a controlled collapse chip connection (C4), copper pillar (CuP) connections, and/or the like. These structures enhance mechanical robustness and facilitate power and signal delivery across semiconductor devices. In various implementations, first die 114 needs to be powered with current coming from substrate 102. As such, one or more through-silicon vias (TSVs) may extend through a portion of the second die 110 to provide a connection between backside bump 108 and first die 114. The terms "through silicon via" or "TSV" may refer to a vertical interconnect that extends through silicon substrates or dies to connect one or more layers in a 3D integrated circuit. It is to be appreciated that the strategic positioning of TSVs plays an important role in improving the efficacy of power delivery and distribution within a semiconductor device. Effective placement of the TSVs ensures that current is distributed uniformly across the circuits, minimizing potential power disparities and optimizing the overall performance of the semiconductor device. In various embodiments, TSVs may be configured within close proximity to one another to allow for power delivery distributed amount TSVs.

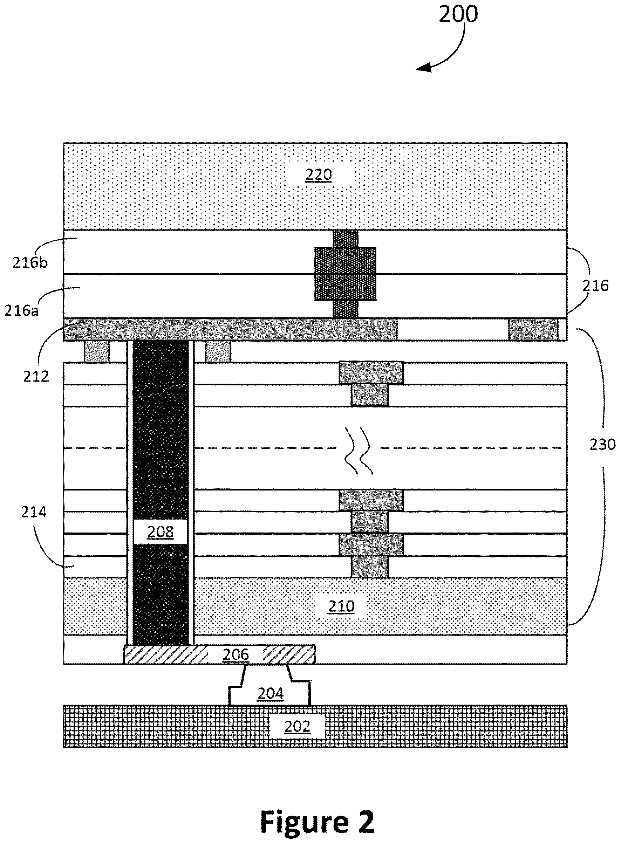

Figure 2 is a simplified diagram illustrating a semiconductor device 200 with a 3D interconnect structure according to the embodiments of the subject technology. This diagram is merely an example, which should not unduly limit the scope of the claims. One of ordinary skill in the art would recognize many variations, alternatives, and modifications. As shown, semiconductor device 200 may include a first circuit 220 and a second circuit 230. For example, first circuit 220 and second circuit 230 may be vertically stacked together via an interconnect 216. Interconnect 216 may further include a first interconnect bond 216a and a second interconnect bond 216b. As an example, first interconnect bond 216a and/or second interconnect bond 216b may include a hybrid copper bond, which can include a fusion of copper-based materials that facilitate electrical connection and thermal performance between first circuit 220 and second circuit 230.

In various implementations, second circuit 230 includes a first connection 212, which is configured to couple to interconnect 216 to establish an electrical connection between first circuit 220 and second circuit 230. For instance, first connection 216 may include, but is not limited to a power grid strap, a metal layer, conductive traces, micro-wires, and/or the like. In some cases, second circuit 230 further includes a transistor 210. Transistor 210 may be used to create logic gates and various digital circuits, which can be configured for various function executions (e.g., signal processing, data computation, etc.) and ensure efficient circuit operations. Depending on the implementations, second circuit 230 may further include one or more metal layers 214 to establish interconnects between transistor 210 and first connection 212 and/or among various circuit elements of second circuit 230, ensuring uninterrupted signal flow and power distribution. In an example, metal layer 214 may be made of copper or aluminum and is formed through a physical vapor deposition (PVD) process such as sputtering or evaporation.

In various implementations, first circuit 220 and second circuit 230 may be stacked on an interposer 202, which is configured to facilitate integration between the stacked circuits (e.g., first circuit 220 and second circuit 230) and the package substrate (e.g., substrate 102 of Figure 1). For instance, second circuit 230 can be coupled to interposer 202 via a second connection 204, which provides a robust physical connection and efficient electrical conduction. As an example, second connection 204 may include, but is not limited to, a solder bump, a micro-bump, a controlled collapse chip connection (C4), copper pillar (CuP) connections, and/or the like.

Depending on the implementation, semiconductor 200 further includes a first via 208. First via 208 may be configured to connect one or more components of semiconductor device 200 for electrical communication and power delivery. For instance, the term "via" refers to a structure that facilitates a vertical electrical connection between different layers or components within a semiconductor device. First via may include, without limitation, a through-silicon via, a blind via, a thermal via, a buried via, and/or the like. As an example, first via 208 may include a through-silicon via.

In some cases, first via 208 may be coupled to a grid 206 to receive electrical power from second connection 204 and transmit the electrical power to second circuit 230 and first circuit 220. For example, the term "grid" may refer to a systematic network of interlinking lines or tracks which serve as conduits for distributing power, signals, or grounds across the semiconductor device. Grids might be realized in diverse configurations ranging from regular structures with uniform spacing to custom designs tailored for specific routing or power needs. Grid 206 may include, without limitation, power distribution grids, clock grids, ground grids, and/or the like. In some embodiments, grid 206 may include a conductive layer and is configured to reroute or redistribute connection points. It is to be appreciated that the incorporation of grid 206 allows the positioning of TSV 208 to be decoupled from second connection 204, offering a dynamic solution to circuit layout and power delivery challenges. It enables circuit designers to optimize circuit layouts for optimal performance, power efficiency, and space utilization.

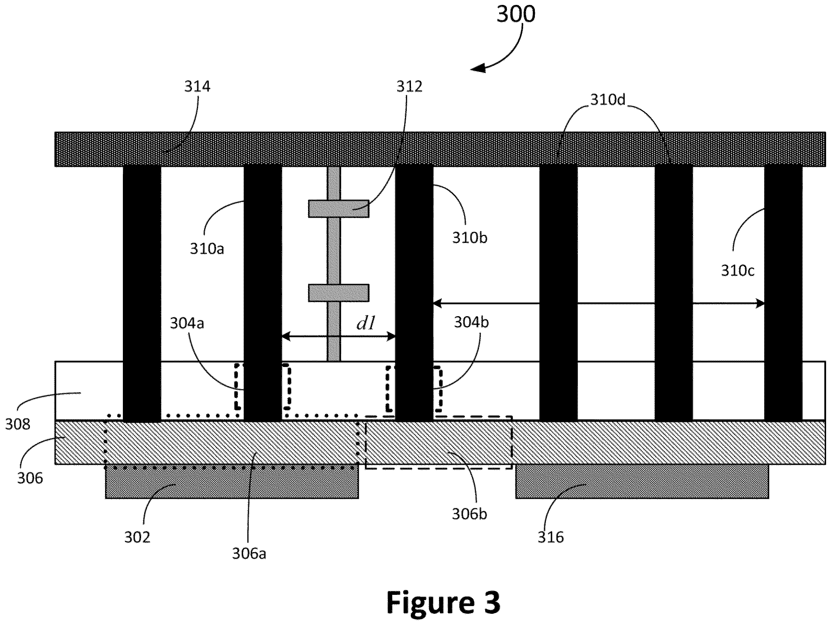

Figure 3 is a simplified diagram illustrating a semiconductor device 300 with a 3D interconnect structure according to embodiments of the subject technology. This diagram is merely an example, which should not unduly limit the scope of the claims. One of ordinary skill in the art would recognize many variations, alternatives, and modifications. As shown, semiconductor device 300 includes a substrate 308, which may include a first side and a second side. As an example, the term "substrate" can refer to a circuit board, on which integrated circuits and other electrical connections are mounted. The substrate can provide a stable platform for the components, along with the necessary electrical connections for them to interact and function as a complete system.

In various implementations, semiconductor device 300 further includes a first connection 314, which may be coupled to the first side of substrate 308. For example, first connection 314 may include a power grid strap. The term "power grid strap" may refer to a conductive layer (e.g., a metal layer) configured to distribute power across the semiconductor device, ensuring consistent voltage levels and improving power delivery efficiency. In some cases, first connection 314 may be configured to connect to another semiconductor module (e.g., a circuit, chip, or other semiconductor devices) for power delivery and signal transmission.

In some embodiments, semiconductor device 300 further includes a grid 306 coupled to the second side of substrate 308. For example, grid 306 may include a conductive layer and is configured to reroute or redistribute connection points. A second connection 302 may be coupled to grid 306. For example, second connection 302 include, but is not limited to, a solder bump, a micro-bump, a controlled collapse chip connection (C4), copper pillar (CuP) connections, and/or the like. Second connection 302 may be configured to provide electrical power to first connection 314 through one or more vias. Depending on the application, second connection 302 may be characterized by a maximum current to satisfy the power delivery requirement of the semiconductor device. The term "maximum current" may refer to the peak electrical current that an electrical component can safely and reliably handle without overheating or causing electrical failure. The maximum current is an important consideration in semiconductor design, which is associated with power delivery capacity and efficiency of the semiconductor device. For instance, a maximum current of second connection 302 may range between 300 milliamps (mA) to 400 mA.

In certain embodiments, a first via 310a can be configured to couple to first connection 314 and grid 306 to establish a power delivery path and transmit electrical power between the first side and the second side. For example, first via 310a may include a TSV. Depending on the implementation, grid 306 may include a first region 306a, and a second region 306b. First via 310a may be coupled between first connection 314 and first region 306a of the grid 306. First region 306a may be coupled to second connection 302. In some cases, substrate 308 may include a first opening, and first via 310a may include a first portion 304a positioned in the first opening. In an example, first via 310a is characterized by a maximum current of less than 40mA. For example, for a high level of power delivery, many TSVs are configured within close proximity of one another (e.g., 10um between two adjacent TSVs) to allow for a high-power throughput.

According to some embodiments, to satisfy the power delivery requirement of second connection 302, semiconductor 300 may further include a second via 310b. Second via 310b may include a TSV. For example, second via 310 may be coupled between first connection 314 and second region 306b of grid 306. Second region 306b is not coupled to second connection 302. For instance, substrate 308 may further include a second opening, and second via 310b may include a second portion 304b positioned in the second opening. It is to be appreciated that grid 306 allows first via 310a and second via 310b to decouple from second connection 302, thereby enhancing design flexibility and optimizing power distribution. Accordingly, a first distance between first TSV 310a and second TSV 310b may be strategically parameterized to meet the power density requirement of the underlying circuitry. In an example, the first distance may be less than 20um (and in some instance, less than 10um). The strategic placement of first via 310a and second via 310b not only optimizes the real estate available for circuit layouts but also accommodates additional circuit elements for complex operations. For instance, circuit element 312 may be positioned between first via 310a and second via 310b. Circuit element 312 may include, but is not limited to, transistors, memory cells, capacitors, resistors, and other components for facilitating various operations (e.g., signal amplification, data storage, data computation, and/or the like).

In some embodiments, semiconductor device 300 further includes a third via 310c and a plurality of vias 310d. The plurality of vias 310d may be positioned between third via 310c and second via 310b. A second distance between third via and second via 310b may be less than 20um. In some cases, semiconductor device 300 may further include a third connection 316. Third connection 316 may be coupled to grid 306. Depending on the implementation, a distance between second connection 302 and third connection 316 may be between 100um to 200um. The flexible placements of TSVs further enhance the device's performance, offering a broader spectrum of connectivity options and facilitating power delivery and distribution across the semiconductor landscape.

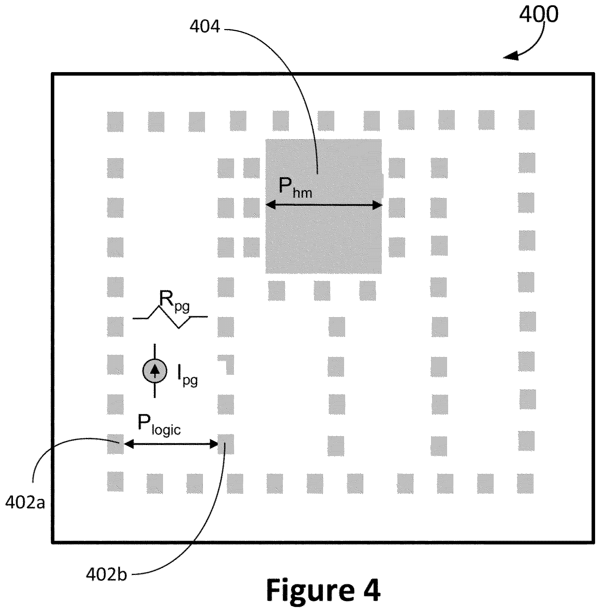

Figure 4 is a simplified diagram illustrating a top view of a semiconductor device 400 having one or more vias according to embodiments of the subject technology. This diagram is merely an example, which should not unduly limit the scope of the claims. One of ordinary skill in the art would recognize many variations, alternatives, and modifications. As shown, semiconductor device 400 includes a number of TSVs, which establish a power distribution network for supplying power to logic units and circuit elements across the semiconductor device. For instance, semiconductor device 400 includes a first TSV 402a and a second TSV 402b. Depending on the implementation, a plurality of TSVs may be clustered together or be configured in close proximity to each other to meet the power delivery requirements of the system while minimizing wiring resources and maximizing circuit utilization.

As previously noted, a grid (e.g., grid 306 of Figure 3)-on which the TSVs are laid out-allows the TSV placement to be configured to match the power density and circuit layout requirements, accounting for various factors including, but not limited to, circuit size, circuit structure, TSV resistance, power grid effective resistance R_{pg}, maximum current of local circuits I_{pg}, input/output, or the like. As an example, a distance P_{logic} between first TSV 402a and second TSV 402b may be associated with the power density of the underlying circuit and power grid resources available. For instance, a standard cell can be configured between and powered by first TSV 402a and second TSV 402b. The term standard cell may refer to one or more transistors or interconnect structures that provide logic functions or storage functions.

In various implementations, for a specialized logic unit 404, which may refer to predesigned blocks or components optimized for specific functionalities. For instance, specialized logic unit 404 may include, without limitation, Static Random-Access Memory (SRAM), Dynamic Random-Access Memory (DRAM), High-Speed I/O controllers, neural network processors, AI accelerators, and/or the like. Due to their intricate design and operation specifics, these logic units typically necessitate higher power density. Under such circumstances, the TSVs can be densely oriented around logic unit 404, ensuring a consistent and robust power influx for seamless system performance. As shown in Figure 4, logic unit 404 may be coupled between TSVs that are characterized by a distance Pₕₘ, which is associated with the circuit layout and power density requirement of logic unit 404. The strategic positioning of TSVs bolsters the timing accuracy, energy efficiency, and overall spatial optimization of the logic embedded within the semiconductor device.

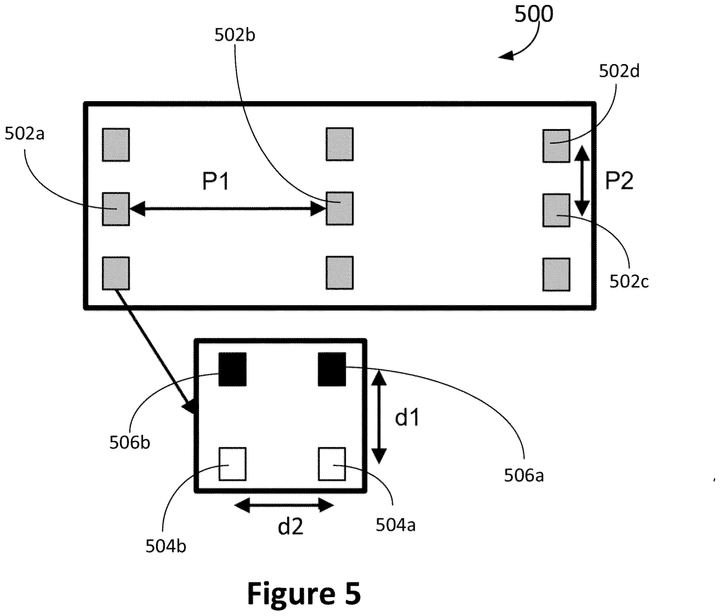

Figure 5 is a simplified diagram illustrating configurations of one or more vias in semiconductor devices 500 according to embodiments of the subject technology. This diagram is merely an example, which should not unduly limit the scope of the claims. One of ordinary skill in the art would recognize many variations, alternatives, and modifications. As previously noted, the power density specific to certain circuit regions allows for a tailored calculation of the requisite TSVs and their optimal configuration, ensuring minimal wiring resources are expended. This in turn optimizes the timing, power, and spatial utility of the logic across the semiconductor device.

In some embodiments, semiconductor device 500 may include a first TSV unit 502a and a second TSV unit 502b. Depending on the implementation, a first pitch between first TSV unit 502a and second TSV unit 502b P1 may be less than or equal to 90um. Each of the TSV units may include one or more TSVs in order to satisfy the power density requirement of the underlying circuits. For instance, first TSV unit 502a may include a first TSV 504a and a second TSV 504b configured for power delivery. First TSV unit 502a may further include a third TSV 506a and a fourth TSV 506b configured for grounding purposes. A first distance d1 between third TSV 506a and first TSV 504a may be less than 7um. A second distance d2 between first TSV 504a and second TSV 504b may be less than 7um. In some embodiments, semiconductor device 500 may further include a third TSV unit 502c and a fourth TSV unit 502d. A second pitch between third TSV unit 502c and fourth TSV unit 502d may be less than 30um.

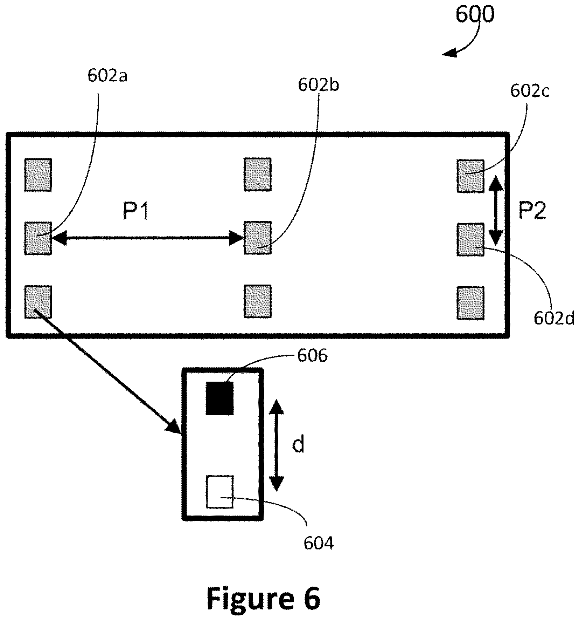

Figure 6 is a simplified diagram illustrating configurations of one or more vias in semiconductor devices 600 according to embodiments of the subject technology. This diagram is merely an example, which should not unduly limit the scope of the claims. One of ordinary skill in the art would recognize many variations, alternatives, and modifications.

In various implementations, semiconductor device 600 may include a first TSV unit 602a and a second TSV unit 602b. Depending on the implementation, a first pitch between first TSV unit 602a and second TSV unit 602b P1 may be less than or equal to 45um. Each of the TSV units may include one or more TSVs in order to satisfy the power density requirement of the underlying circuits. For instance, first TSV unit 602a may include a first TSV 604 configured for power delivery and a second TSV 606 configured for grounding purposes. A distance between first TSV 604 and second TSV 606 may be less than 7um. In some embodiments, semiconductor device 600 may further include a third TSV unit 602c and a fourth TSV unit 602d. A second pitch between third TSV unit 602c and fourth TSV unit 602d may be less than 30um.

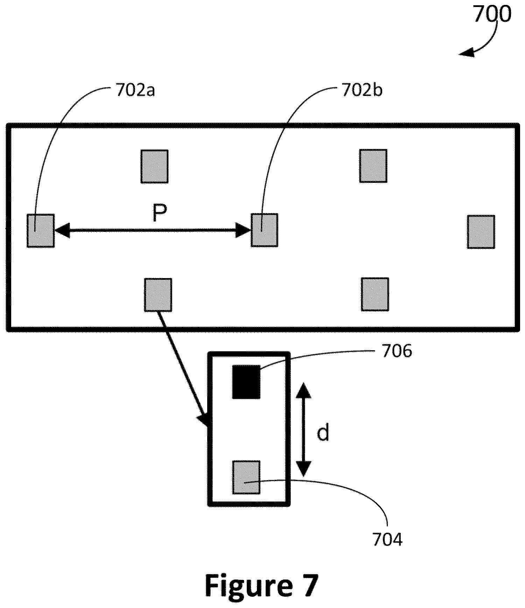

Figure 7 is a simplified diagram illustrating configurations of one or more vias in semiconductor devices 700 according to embodiments of the subject technology. This diagram is merely an example, which should not unduly limit the scope of the claims. One of ordinary skill in the art would recognize many variations, alternatives, and modifications.

According to some embodiments, semiconductor device 700 may include a first TSV unit 702a and a second TSV unit 702b. Depending on the implementation, a pitch between first TSV unit 702a and second TSV unit 702b P may be less than or equal to 45um. Each of the TSV units may include one or more TSVs in order to satisfy the power density requirement of the underlying circuits. For instance, first TSV unit 702a may include a first TSV 704 configured for power delivery and a second TSV 706 configured for grounding purposes. A distance between first TSV 704 and second TSV 706 may be less than 7um.

While the above is a full description of the specific embodiments, various modifications, alternative constructions and equivalents may be used. Therefore, the above description and illustrations should not be taken as limiting the scope of the subject technology which is defined by the appended claims.

## Claims

1. A semiconductor device, comprising:
a first connection;
a substrate comprising a first side and a second side, the first connection being coupled to the first side;
a grid coupled to the second side;
a second connection coupled to the grid;
a first via coupled to the first connection and the grid; and
a second via coupled to the first connection and the second connection,
a first distance between the first via and the second via being less than 20um.

2. The device of claim 1, wherein
the first via is **characterized by** a maximum current of less than 40mA.

3. The device of claim 1 or 2, wherein
the first connection comprises a power grid strap.

4. The device of any one of the claims 1 to 3, wherein
the second connection comprises a solder bump.

5. The device of any one of the claims 1 to 4, wherein
the first via comprises a through silicon via.

6. The device of any one of the claims 1 to 5, further comprising
a third connection coupled to the grid, a distance between the second connection and the third connection is between 100um to 200um.

7. The device of any one of the claims 1 to 6, wherein
the first via is configured to transmit electrical power between the first side and the second side.

8. A semiconductor device comprising:
a first connection;
a substrate comprising a first opening and a second opening, the substrate comprising a first side and a second side, the first connection being coupled to the first side;
a grid coupled to the second side;
a second connection coupled to the grid;
a first via coupled to the first connection and the grid, the first via comprising a first portion positioned in the first opening; and
a second via coupled to the first connection and the grid, the second via comprising a second portion positioned in the second opening,
a first distance between the first via and the second via being less than 20um.

9. The device of claim 8, further comprising
a third via and a plurality of vias, the plurality of vias being positioned between the third via and the second via, a second distance between the third via and the second via being less than 20um.

10. The device of claim 8 or 9, wherein
the first via is **characterized by** a maximum current of less than 40mA;
and/or
the first via comprises a through silicon via.

11. A semiconductor device, comprising:
a substrate comprising a first side and a second side;
a first connection coupled to the first side of the substrate;
a grid coupled to the second side of the substrate, the grid comprising a first region; and
a first via coupled between the first connection and the first region of the grid,
the first via comprising a first portion positioned in a first opening of the substrate.

12. The semiconductor device of claim 11, further comprising
a second connection coupled to the first region of the grid.

13. The semiconductor device of claim 12, wherein
the second connection comprises a solder bump.

14. The semiconductor device of claim 12 or 13, wherein
the grid further comprises a second region, the second region is not coupled to the second connection;
wherein in particular the semiconductor device further comprises
a second via coupled between the first connection and the second region of the grid, the second via comprising a second portion positioned in a second opening of the substrate;
wherein further in particular
a first distance between the first via and the second via is less than 20um.

15. The semiconductor device of any one of the claims 11 to 14, wherein
the first connection comprises a power grid strap;
and/or wherein
the first via is configured to transmit electrical power between the first side and the second side;
wherein in particular
the first via is **characterized by** a maximum current of less than 40mA.
